# FASCICULE DE BREVET EUROPEEN

(11) **EP 2 144 285 B1**
(45) Date de publication et mention de la délivrance du brevet: **17.10.2018**
(21) Numéro de dépôt: 09164594.5
(22) Date de dépôt: 03.07.2009
(51) Int. Cl.: H01L 21/67, H01L 21/677

(54) **Dispositif de chargement/déchargement de substrats**
Vorrichtung zum Be- und Entladen von Substraten
device for loading and unloading substrates

(30) Priorité: 11.07.2008 FR 0854753
(43) Date de publication de la demande: 13.01.2010
(73) Titulaire: Pfeiffer Vacuum, 74000 Annecy (FR)
(72) Inventeur: Godot, Erwan, 74009, ANNECY (FR); Veran, Emmanuelle, 74009, ANNECY (FR)
(74) Mandataire: Croonenbroek, Thomas Jakob

(56) Documents cités:
- EP-A- 1 457 829
- WO-A-2007/141447
- JP-A- 11 087 459
- US-A1- 2005 186 716

## Description

La présente invention concerne le domaine du transport, du stockage et du transfert de plaquettes de substrats semi-conducteurs (« wafers » en anglais), notamment entre les différentes étapes de la fabrication de composants microélectroniques, par exemple pour la réalisation de composants de microsystèmes électromécaniques (MEMS) ou de microsystèmes électrooptomécaniques (MOEMS). L'invention se rapporte plus particulièrement à un dispositif pour le chargement et le déchargement de ces substrats apte à être accouplé à une installation de fabrication et de traitement de ces substrats.

Dans les dispositifs actuellement utilisés, entre les différentes étapes de fabrication des semi-conducteurs, les substrats sont transportés et stockés à la pression atmosphérique dans des boîtes de transport qui les protègent des pollutions particulaires présentes dans l'atmosphère des salles blanches. Une boîte de transport comporte une paroi périphérique étanche à ouverture d'entrée-sortie obturable par une porte de boîte à moyens d'étanchéité. Les substrats se présentent notamment sous la forme de masques de forme carrée ou de tranches de forme circulaire en matériau semi-conducteur tel que le silicium. Dans une boîte de transport, les substrats sont empilés les uns à proximité des autres dans une sorte de râtelier que l'on désigne également par les appellations cassette ou panier.

On utilise actuellement un premier type de boîte de transport désigné par l'acronyme SMIF (pour « Standardized Mechanical Interface » en anglais). Une telle boîte de transport comporte un corps de boîte en forme de cloche reposant sur une plaque de base qui ferme son ouverture inférieure et constitue une porte. Le panier est généralement posé ou tenu sur la plaque de base. Les substrats sont empilés horizontalement dans le panier.

On utilise aussi un deuxième type de boîte de transport, désigné par l'acronyme FOUP (pour « Front Opening Unified Pod » en anglais), comportant un corps de boîte à ouverture latérale.

Les boîtes de transport doivent pouvoir être accouplées avec des interfaces d'entrée-sortie des installations de fabrication de composants semi-conducteurs ou de traitement de substrats. On réalise l'accouplement des boîtes de transport avec les équipements par des moyens assurant l'étanchéité permanente vis-à-vis de l'atmosphère extérieure dans la salle blanche.

L'interface est un système permettant le positionnement de la boîte de transport, l'ouverture de sa porte de boîte, et la préhension et le transport du substrat pour un transfert entre la boîte de transport et l'équipement. Cette interface, appelée parfois aussi minienvironnement, est désignée par la suite par le terme module frontal d'équipement, ou plus simplement module, et par l'acronyme EFEM (pour « Equipment Front End Module » en anglais).

Le module EFEM sous pression atmosphérique comporte des moyens robotisés qui transporte chaque substrat depuis la boite de transport vers un sas de chargement / déchargement (désigné par le terme anglais « load lock ») qui communique avec une chambre de transfert précédant une chambre de procédé. Lors du chargement, les substrats sont transférés de la boîte de transport dans le sas sous pression atmosphérique. Le sas de chargement est alors mis sous une très basse pression. Puis le robot de la chambre de transfert transporte le substrat depuis le sas de chargement jusqu'à la chambre de procédé sous vide où a lieu le traitement. Lorsque le traitement est terminé, l'opération inverse de déchargement du substrat de la chambre de procédé vers la boite de transport nécessite une remontée à la pression atmosphérique du sas de chargement avant le transfert du substrat à l'aide des moyens robotisés vers le module EFEM et la boite de transport.

Ces variations de pression gazeuse nécessitent des opérations de pompage et de remise à pression atmosphérique qui provoquent des flux gazeux susceptibles de provoquer des contaminations particulaires du sas de chargement et donc des substrats. Il est donc particulièrement nécessaire de limiter les contaminations possibles, de façon à augmenter la productivité des installations de fabrication de semiconducteurs. On s'efforce donc de minimiser les phénomènes d'oxydation et de corrosion des substrats pendant les phases de traitement, les phases d'attente dans la boîte de transport entre deux étapes du procédé ou les phases de transfert d'un équipement de traitement des semiconducteurs à un autre.

Une solution est de mettre en oeuvre des solutions de purge en fin de traitement, mais pour certaines nouvelles technologies les phénomènes d'oxydation ou de corrosion interviennent avant même la fin du traitement d'un lot complet de substrats. Cela oblige les fabricants à diviser les lots et à traiter chaque partie successivement, ce qui conduit à l'augmentation du temps total de traitement du lot.

Une autre solution consiste à réduire les phases d'attente entre deux étapes du procédé, mais cela nécessite d'augmenter le nombre d'équipements et soulève des problèmes de coût.

Toutefois l'inconvénient du système comprenant un module EFEM associé à une boîte de transport est son incapacité à s'accoupler simultanément à deux équipements, de manière à permettre le transfert direct des substrats d'un équipement à un autre, comme c'est le cas par exemple de la boîte de transport décrite dans le document WO-2007/141447.

On entend par équipement, toute structure à laquelle on désire accoupler une boite de transport pour le transfert de substrat. Un tel équipement peut être par exemple un module EFEM, un sas de chargement / déchargement ou une chambre de transfert.

La présente invention a donc pour but de réduire le nombre d'opérations de transferts des plaquettes de substrats au cours de leur traitement en autorisant la connexion simultanée des boites de transport à plusieurs équipements de façon à permettre le transfert direct des substrats d'un équipement à un autre, sans déconnexion et extraction de la boîte de transport.

L'invention à aussi pour but de proposer une boîte de transport comprenant les moyens pour réaliser facilement ces transferts.

L'invention a encore pour but de fournir un dispositif capable de coopérer avec les équipements tels qu'ils existent dans les installations de fabrication de composants semiconducteur actuellement en service.

L'objet de la présente invention est un dispositif selon l'objet de la revendication 1.

La présente invention propose ainsi un dispositif capable de se connecter simultanément à plusieurs équipements. Le dispositif permet aussi le transport de la boite qui lui est connectée d'un équipement de traitement à l'autre sans remise à pression atmosphérique des substrats. Le dispositif selon l'invention est aussi appelé par la suite sas de chargement / déchargement mobile MLL (« mobile load lock » en anglais).

Selon un premier mode de réalisation de l'invention, le dispositif est capable de se connecter simultanément à une chambre de transfert, à un module EFEM de transfert de wafers à pression atmosphérique et à une boîte de transport, qui peut être mise sous vide. Dans ce cas le dispositif peut ainsi être utilisé en lieu et place d'un sas de chargement / déchargement classique sur des installations de fabrication de semi-conducteurs.

Selon un deuxième mode de réalisation, le dispositif est capable de se connecter simultanément à une première chambre de transfert, à une deuxième chambre de transfert et à une boîte de transport.

Selon un troisième mode de réalisation, le dispositif est capable de se connecter simultanément à une chambre de procédé, à une chambre de transfert et à une boîte de transport.

Selon un quatrième mode de réalisation, le dispositif est capable de se connecter simultanément à une chambre de procédé, à un module EFEM et à une boîte de transport.

Selon une première variante de l'invention, le dispositif comporte en outre des moyens d'actionnement de porte pour ouvrir et fermer la porte obturant respectivement chaque orifice. Le dispositif peut aussi comporter des moyens pour solidariser la porte de la boîte de transport avec la porte du troisième orifice par des moyens mécaniques ou magnétiques. Les moyens d'actionnement de la porte fermant le troisième orifice peuvent assurer aussi la fonction de moyens de déplacement du panier.

Selon une deuxième variante, le dispositif comporte en outre des moyens d'étanchéité au niveau de la zone d'accouplement d'un orifice à un équipement.

Selon une troisième variante, le dispositif peut encore comporter des moyens pousseurs aptes à appliquer sur la porte de la boîte de transport une poussée axiale pour comprimer les moyens d'étanchéité. Les moyens pousseurs sont placés de préférence à l'extérieur de la paroi étanche du dispositif afin de minimiser le risque de contamination des plaquettes de substrat.

Selon une forme d'exécution de l'invention, les moyens de blocage des plateaux comportent des doigts de verrouillage coopérant avec des moyens d'actionnement de doigts. De préférence le doigt de verrouillage est muni d'une encoche qui coopère avec le plateau.

Selon une autre forme d'exécution, les moyens de pose et de soutien de la plaquette comprennent des bras de pose coopérant avec des moyens d'actionnement de bras.

Avantageusement les moyens d'actionnement sont des actionneurs à pression atmosphérique.

Les moyens de pose et de soutien de la plaquette comprennent des cales, par l'intermédiaire desquelles le substrat repose sur le plateau.

Les moyens de pose et de soutien de la plaquette comprennent la combinaison de bras de pose, coopérant avec des moyens d'actionnement de bras, et de cales disposées entre le plateau et la plaquette. Les cales permettent de décoller la plaquette du plateau et ménagent un intervalle dans lequel s'insèrent les bras de pose.

Les moyens de déplacement de la plaquette sont de préférence des pelles motorisées incluses dans les équipements auxquels le dispositif selon l'invention est relié.

Pour transférer des substrats depuis une boîte de transport de type SMIF vers un équipement, la boîte de transport est posée sur le dispositif selon l'invention. La porte inférieure de la boîte est ouverte et on fait descendre le panier et l'ensemble des substrats qu'il contient jusque dans le volume intérieur du dispositif. Les plateaux sont alors séparés en deux groupes grâce aux moyens de blocage de manière à permettre aux moyens de soutien d'avancer pour se placer sous une plaquette de substrat, alors que le plateau qui la supportait continue sa descente. Lorsque les deux groupes de plateaux sont écartés les uns des autres de manière suffisante, la préhension d'une plaquette choisie et son déplacement à l'écart de son support peuvent être effectués par un moyen robotisé. Les plaquettes de substrat sont ainsi déplacées une à une par une pelle robotisée pour être introduites dans l'un ou l'autre des équipements connectés.

L'invention a comme avantage de permettre un chargement de la boîte de transport aussi bien à pression atmosphérique que sous vide. Le dispositif selon l'invention permet de charger sous vide un grand nombre de substrats, évitant ainsi les opérations de pompage et de remise à pression atmosphérique pour chaque substrat, et diminuant d'autant les risques de pollution. Le transfert est réalisé entièrement sous vide, il n'y a donc plus de problème d'oxydation.

L'invention a aussi pour objet une installation pour le traitement de substrats comprenant une chambre de procédé communiquant avec une première chambre de transfert, et au moins un dispositif tel que décrit précédemment, communiquant avec la première chambre de transfert, avec un module EFEM ou une deuxième chambre de transfert, et avec une boîte de transport.

Selon un premier mode de réalisation de l'invention, l'installation comprend au moins un dispositif tel que décrit précédemment, communiquant avec une première chambre de transfert, avec un module EFEM et avec une boîte de transport.

Selon un deuxième mode de réalisation de l'invention, l'installation comprend au moins un dispositif tel que décrit précédemment, communiquant avec une première chambre de transfert, avec une deuxième chambre de transfert et avec une boîte de transport.

L'invention a encore pour objet une installation pour le traitement de substrats comprenant une chambre de procédé et au moins un dispositif tel que décrit précédemment, communiquant avec la chambre de procédé, avec un module EFEM ou une chambre de transfert, et avec une boîte de transport.

Selon un troisième mode de réalisation de l'invention, l'installation comprend au moins un dispositif tel que décrit précédemment, communiquant avec une chambre de procédé, avec une chambre de transfert et avec une boîte de transport.

Selon un quatrième mode de réalisation de l'invention, l'installation comprend au moins un dispositif tel que décrit précédemment, communiquant avec une chambre de procédé, avec un module EFEM et avec une boîte de transport.

Selon un premier aspect, l'installation selon l'invention peut être utilisée pour le stockage intermédiaire des plaquettes de substrat sans déconnection du dispositif de l'installation.

Selon un deuxième aspect, l'installation selon l'invention peut être utilisée pour la qualification d'un procédé.

Selon un troisième aspect, l'installation selon l'invention peut être utilisée pour le tri d'un lot de substrat ou le mélange de substrats provenant de lots différents.

Le dispositif selon l'invention permet de réaliser de nombreuses applications de transfert et manipulation de substrats qui seront expliquées plus en détail ci-après, notamment le tri de substrats, le stockage de substrat sous vide sans désolidarisation de l'installation comportant la chambre de procédé, une qualification d'équipement de traitement ou décontamination d'équipement de traitement, sans contamination des autres substrats. Grâce à l'invention, les opérations de maintenance peuvent être réalisées sans arrêter l'installation de traitement, ce qui représente un gain de temps et de coûts pour les fabricants de composants semi-conducteurs.

En outre cette solution est compatible avec les systèmes existants, il n'est donc pas nécessaire d'effectuer des changements importants sur l'installation.

D'autres caractéristiques et avantages de la présente invention apparaîtront à la lecture de la description qui suit d'un mode de réalisation, donné bien entendu à titre illustratif et non limitatif, et dans le dessin annexé sur lequel
- la figure 1 représente schématiquement une installation de traitement de substrats selon le premier mode de réalisation de l'invention,
- la figure 2 est une vue de côté schématique du dispositif selon un mode de réalisation de l'invention,
- la figure 3 est une vue de dessus schématique du dispositif de la figure 2,
- la figure 4 est une vue de côté schématique d'un mode de réalisation des moyens de blocage des plateaux,
- la figure 5 est une vue schématique de côté d'un mode de réalisation des moyens de soutien d'une plaquette de substrat,
- la figure 6 est une vue schématique de dessus des moyens de soutien d'une plaquette de substrat de la figure 5,
- les figures 7a à 7d montrent les étapes successives de déchargement d'une plaquette de substrat au moyen du dispositif selon un mode de réalisation de l'invention,
- la figure 8 représente schématiquement une installation de traitement de substrats selon le deuxième mode de réalisation de l'invention,
- la figure 9 représente schématiquement une installation de traitement de substrats selon un mode particulier de réalisation de l'invention.

Sur les figures, les flèches indiquent la direction de déplacement des pièces.

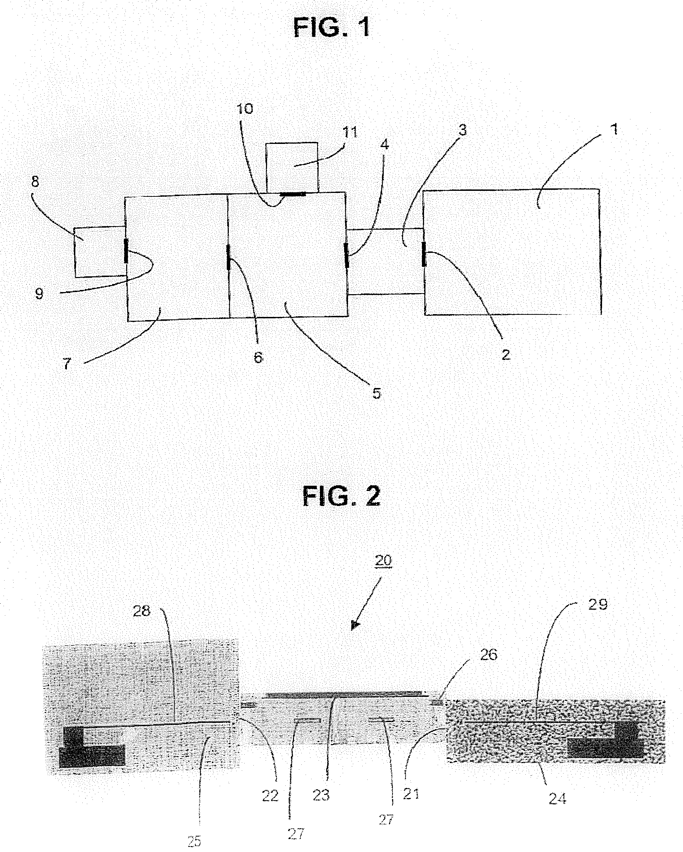

Une installation de traitement de substrat selon le premier mode de réalisation de la présente invention est représentée sur la figure 1. Elle comprend une chambre de procédé **1,** maintenue sous vide dans laquelle s'effectuent les opérations de fabrication ou de traitement de substrats, notamment de plaquettes de substrats semi-conducteurs. La chambre de procédé **1** communique par un orifice **2** avec une chambre de transfert **3** également sous vide dans laquelle est placée la plaquette de substrat immédiatement avant et après son traitement dans la chambre de procédé **1.** La chambre de transfert **3** communique par un orifice **4** avec un sas de chargement / déchargement **5** dans lequel alternent les phases de mise sous vide et de remise à pression atmosphérique. Ce sas **4** peut permettre de mettre en relation, par un orifice **6,** la chambre de transfert **3** avec un module EFEM **7** dans lequel les substrats sont conservés à pression atmosphérique et auquel une ou plusieurs boites de transport **8,** de type FOUP par exemple, peuvent être connectées par un orifice **9.** Les plaquettes de substrat peuvent ainsi être transférées une à une de la chambre de transfert **3** au module EFEM **7** par l'intermédiaire du sas **5.** Les plaquettes peuvent ensuite être placées dans des boites de transport **8** amovibles qui sont utilisées pour le stockage ou le transport des plaquettes de substrats à pression atmosphérique, notamment entre deux phases de fabrication ou entre deux équipements de traitement différents.

Selon ce mode de réalisation de l'invention, le sas de chargement / déchargement MLL **5** communique en outre par un orifice **10** avec une boîte de transport **11,** comme par exemple une boîte de type SMIF. Étant amovible, ce sas de chargement / déchargement **5** mobile MLL permet de désaccoupler la boîte de transport **11** de l'équipement, et autorise ainsi le transport de la boîte contenant les plaquettes de substrat sous vide vers un autre équipement de traitement. De préférence les parois du sas de chargement / déchargement **5** mobile et de la boîte de transport **11** sont métalliques de manière à pouvoir supporter et conserver le vide.

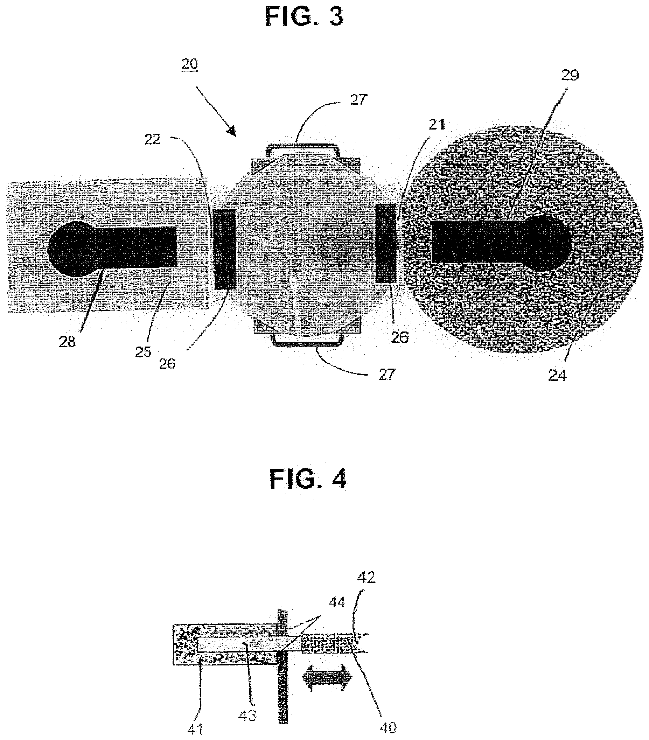

Un mode de réalisation d'un dispositif **20** selon l'invention est représenté sur les figures 2 et 3. Le sas de chargement / déchargement **20** mobile comporte trois orifices d'accès **21, 22** et **23.** Le sas MLL **20** est par exemple relié à la chambre de transfert **24** d'une installation par l'orifice **21** et à un module EFEM **25** par l'orifice **22,** les orifices **21** et **22** étant ménagés dans une des parois latérales. Il est également connecté à une boite de transport (non représentée) par son orifice **23** ménagé dans une paroi inférieure ou de préférence supérieure du dispositif **20.**

Le sas MLL **20** est conçu pour accueillir le panier contenant les plaquettes de substrats contenues dans la boite de transport, et pour assurer le déplacement de ces plaquettes vers les équipements. Dans ce but, le sas MLL **20** comprend des moyens **26** pour bloquer une partie des plateaux du panier dans une position fixée, en laissant les autres plateaux poursuivre leur déplacement. Il comporte aussi des moyens **27** pour déposer et soutenir le substrat choisi alors que le plateau sur lequel il reposait continue sa descente. Enfin il coopère avec les moyens robotisés **28** du module EFEM **25** et les moyens robotisés **29** de la chambre de transfert **24** pour déplacer les substrats vers ces équipements à travers les orifices **21** et **23.**

Les moyens de blocage des plateaux peuvent être par exemple des doigts de verrouillage **40** motorisés comme illustré sur la figure 4, adaptés pour bloquer sélectivement le mouvement vers le bas d'un plateau choisi, empêchant de ce fait ce plateau et ceux qui le surmontent de descendre plus bas à l'intérieur du sas de chargement / déchargement mobile MLL. Ces doigts de verrouillage **40** sont ici au nombre de deux Ils sont sollicités par des actionneurs **41** à pression atmosphérique, ou vérin pneumatiques, qui entraînent leur déplacement dans le plan horizontal vers ou à l'écart des plateaux. L'extrémité de chaque doigt de verrouillage **40** comprend une encoche **42** qui s'emboite dans le plateau permettant d'assurer son maintien. Les actionneurs **41** à pression atmosphérique sont situés à l'extérieur du sas de chargement / déchargement mobile MLL de manière à éviter la contamination particulaire. Des passages étanches **43** assurent la liaison entre les doigts de verrouillages et les actionneurs. Des moyens d'étanchéité **44,** positionnés à la zone de contact entre le passage étanche **43,** les actionneurs **41** et le sas, isolent l'intérieur du sas de l'atmosphère extérieure.

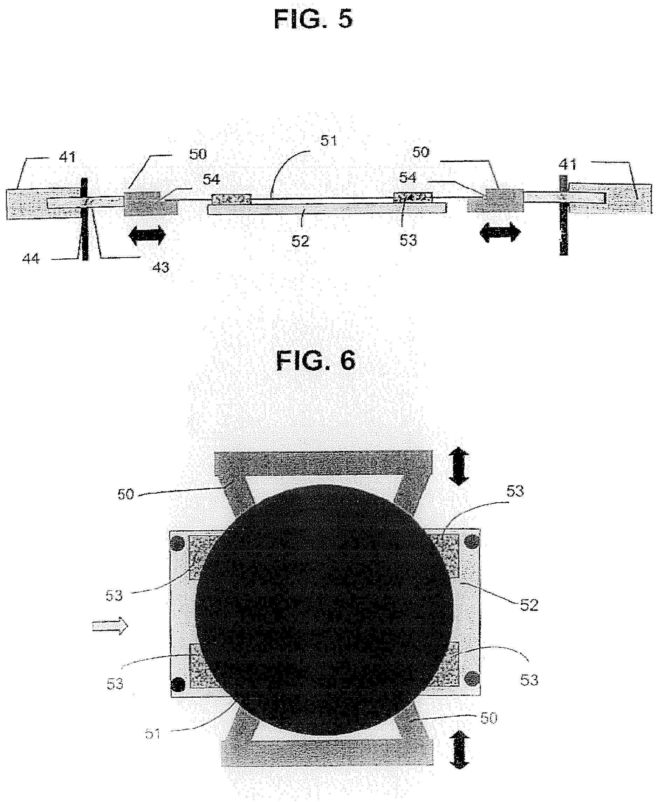

Les moyens de pose et de soutien des substrats comprennent par exemple des bras de pose **50** déplaçables, tels que représenté sur les figures 5 et 6. Le sas de chargement / déchargement mobile MLL comprend ici deux bras de pose **50** qui viennent se glisser sous un substrat **51** et le supporte lors du mouvement vers le bas du plateau **52.** Les moyens de pose et de soutien des substrats comprennent aussi des cales **53,** par l'intermédiaire desquelles le substrat reposait sur le plateau, qui autorisent le passage des bras. On comprend donc qu'au repos, les bras de pose **50** ont une position en retrait dans le sas de chargement / déchargement mobile, de manière à laisser un passage pour le panier. Le bras de pose **50** comporte une butée **54** permettant d'assurer le maintien latéral du substrat.

Dans le sas de chargement / déchargement mobile MLL, les bras de pose **50** sont positionnés en vis-à-vis, de préférence à une hauteur correspondant au milieu des orifices de passage **21** ou **23** de la figure 2, respectivement sur les deux parois perpendiculaires aux parois où sont situés ces deux orifices **21, 23**.

Selon un mode de réalisation avantageux, afin d'éviter la contamination particulaire des substrats, la partie des bras destinée à entrer en contact avec le substrat est réalisée dans un matériau évitant la contamination particulaire, comme par exemple en polyéther éther cétone PEEK ou bien en un copolymère de tétrafluoroéthylène et de perfluoroéthylène ou perfluoroalcoxyalcane PFA .

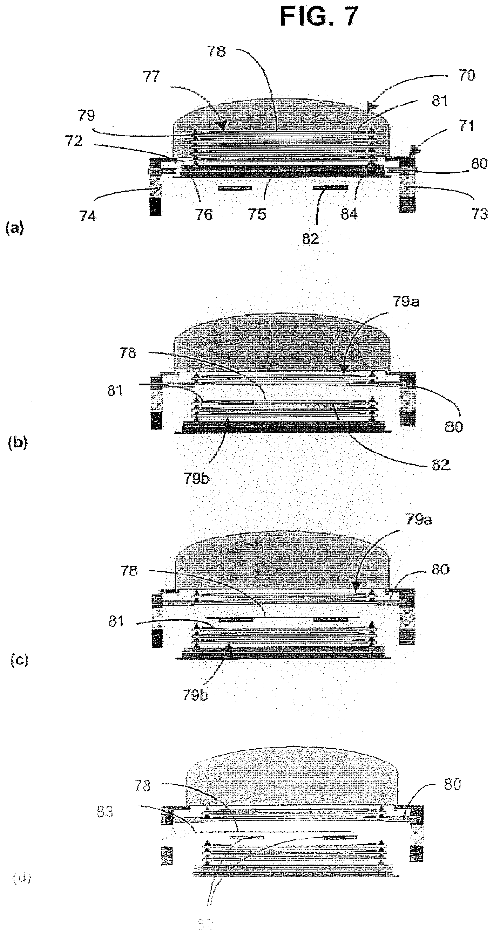

Dans le mode de réalisation de l'invention illustré sur les figures 7a à 7d, on a représenté les étapes du déchargement d'un substrat depuis une boite de transport **70** vers une chambre de transfert par l'intermédiaire d'un dispositif MLL **71** selon un mode de réalisation de la présente invention. Le sas MLL **71** est relié à la boite de transport **70** par son orifice supérieur **72.** Il est également connecté par exemple à la chambre de transfert d'un équipement par un orifice **73** et à un module EFEM par un orifice **74.**

La boîte de transport **70** représentée est une boîte de type SMIF comportant une ouverture inférieure obturable par une porte **75** munie de moyens d'étanchéité tel qu'un joint **76.** La boîte de transport **70** contient un panier **77** dans lequel peuvent être rangées des plaquettes **78** de substrat à transporter. Le panier **77** comprend une série de plateaux parallèles **79** adaptés pour stocker chacun une plaquette **78**.

Le sas de chargement / déchargement **71** mobile selon ce mode de réalisation de l'invention est conçu pour accueillir simultanément plusieurs plaquettes **78** de substrats, puis les transférer sous vide une à une dans une chambre de transfert Depuis la boite de transport **70,** le panier **77** contenant les plaquettes **78** de substrats est déplacé vers l'intérieur du sas **71** par l'orifice **72.**

Dans ce but, le dispositif **71** comprend des moyens de déplacement du panier **77** et de blocage des plateaux **79** dans une position fixée. Les moyens de blocage des plateaux sont par exemple des doigts de verrouillage **80** adaptés pour bloquer sélectivement le mouvement vers le bas d'un plateau choisi, empêchant de ce fait ce plateau et ceux qui le surmontent de descendre plus bas à l'intérieur du dispositif **71.** Les moyens de pose et de soutien des plaquettes **78** de substrat comprennent par exemple en combinaison des cales **81** qui surélèvent les substrats et des bras de pose **82** qui viennent se glisser sous la plaquette **78** de substrat et la supporte lors du mouvement vers le bas du plateau sur lequel elle reposait. Les moyens de déplacement des substrats **78** comprennent par exemple une pelle **83** motorisée qui peut soulever la plaquette **78** de substrat reposant sur les bras de pose **82** et l'éloigner en direction du module EFEM via l'orifice **74.**

On va maintenant expliquer comment s'effectue le transfert des plaquettes de substrat vers l'équipement.

Une fois la boite de transport **70** accostée à l'orifice **72** du dispositif MLL **71,** la connexion est rendue étanche par le joint **76.** La porte **75** de la boite **70** est déverrouillée si elle possède des moyens de verrouillage. La porte **75** de la boite **70** et la porte **84** du dispositif MLL **71** sont rendues solidaire par un système qui peut être magnétique ou mécanique. Lorsque la porte **84** du dispositif **71** est actionnée, la porte **75** de la boite **70** descend avec la porte **84** du sas de chargement / déchargement mobile MLL **71** ainsi que l'ensemble des plateaux **79** formant le panier **77.**

Au cours de la descente du panier **77,** la porte dus sas MLL **71** se stabilise afin de permettre aux doigts de verrouillage **80** de s'avancer pour bloquer la descente du plateau situé juste au-dessus de celui qui porte la plaquette **78** de substrat à transférer, empêchant ainsi la poursuite de la descente d'un premier groupe de plateaux **79a** placés au-dessus des doigts de verrouillage **80.** Le groupe de plateaux **79b** situés en-dessous des doigts de verrouillage **80** poursuivent leur descente jusqu'au moment où le substrat **78** désiré se retrouve à quelques millimètres au-dessus du plan des bras de pose **82.** Les bras de pose **82** s'avancent alors, cependant que le deuxième groupe de plateaux **79b** continue sa descente, et le substrat se retrouve ainsi posé sur les bras **82.**

Une pelle **83** est introduite entre les bras de pose **82** pour venir se positionner sous la plaquette **78** de substrat. Puis cette pelle **83** soulève le substrat qui reposait sur les bras **82.** La pelle **83** peut alors se déplacer en portant la plaquette **78** de substrat pour l'amener dans le module EFEM par l'orifice **74.** Bien que la figure 7d représente le transfert de la plaquette **78** de substrat dans un module EFEM via l'orifice **74,le** transfert de la plaquette **78** dans la chambre de transfert via l'orifice **73** pourra bien entendu être réalisé symétriquement de la même manière sans qu'il soit nécessaire de déplacer le panier **77** ou de modifier son orientation.

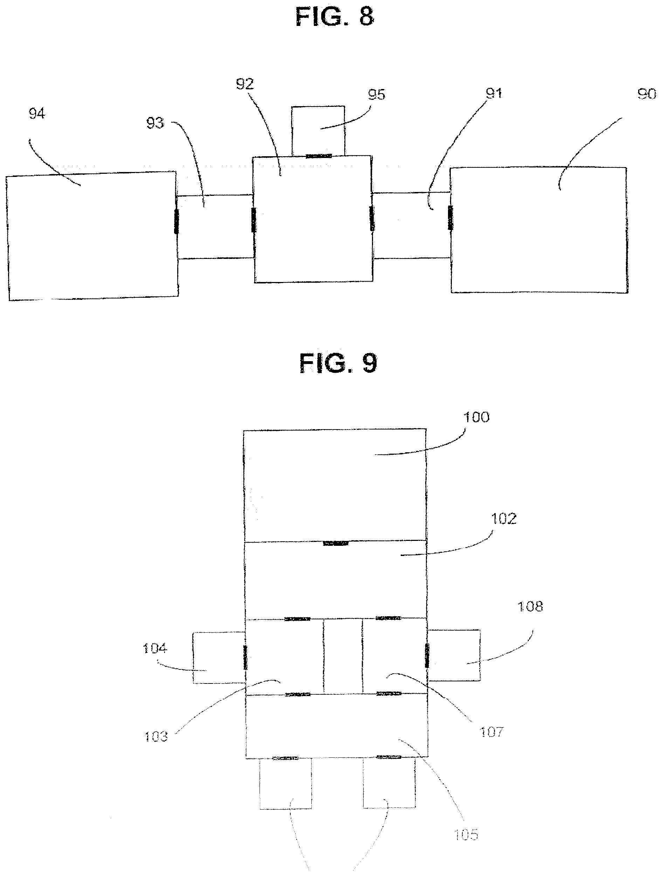

Une installation de traitement de substrat selon le quatrième mode de réalisation de la présente invention est représentée sur la figure 8. Elle comprend une première chambre de procédé **90,** dans laquelle s'effectue un traitement des substrats, communiquant avec une première chambre de transfert **91** dans laquelle est placée la plaquette de substrat immédiatement avant et après son traitement dans la première chambre de procédé **90.** La chambre de transfert **91** communique avec un dispositif MLL **92** qui est simultanément en communication avec une deuxième chambre de transfert **93,** elle-même reliée à une deuxième chambre de procédé **94** dans laquelle s'effectue un autre traitement des substrats. Le sas de chargement / déchargement MLL **92** communique en outre avec une boîte de transport **95** par exemple de type SMIF. Les plaquettes de substrat peuvent ainsi être transférées une à une de la première chambre de procédé **90** à la deuxième chambre de procédé **94** par l'intermédiaire du sas MLL **92.** Les plaquettes peuvent être placées temporairement en attente dans la boite de transport **95** avant chargement dans l'une ou l'autre des chambres de procédé.

Ainsi le dispositif selon l'invention ou sas de chargement / déchargement mobile MLL, associé à une boite de transport qui lui est connectée, permet d'être utilisé dans un grand nombre d'applications impliquant la manipulation de substrats. La figure 9 représente une installation adaptée à certaines de ces applications.

La chambre de procédé **100** communique avec la chambre de transfert **102** qui communique elle-même avec un premier sas de chargement / déchargement **103** connecté à une boîte de transport **104.** Le sas **103** peut permettre de mettre en relation avec un module EFEM **105** auquel une ou plusieurs boîtes de transport **106** peuvent être connectées. La chambre de transfert **102** communique aussi avec un deuxième sas de chargement / déchargement **107,** lui-même connecté à une boîte de transport 108, également relié au module EFEM **105.** La possibilité de connecter simultanément un deuxième sas de chargement / déchargement à la chambre de transfert **102** permet de créer un circuit parallèle ou de traiter un lot urgent, par exemple un substrat de qualification, en mettant en attente un autre lot.

Une première application du dispositif selon l'invention est le stockage intermédiaire des plaquettes de substrat sans désolidarisation du sas MLL **103, 107** de l'installation comportant la chambre de procédé **100.** Lorsque le procédé nécessite un temps assez long, un lot complet comprenant plusieurs substrats à traiter doit être divisé en deux parties. Chacun des demi-lots est placé respectivement dans une boite de transport **106,** par exemple de type FOUP qui peuvent être connectées simultanément au module EFEM 105, lui-même relié aux sas de chargement / déchargement mobile MLL **103, 107.**

Les substrats sont alors transférés un à un de la boite de transport **106** vers un panier disposé dans un premier sas MLL **103** via le module EFEM **105** au moyen de la pelle du robot du module EFEM **105.** Puis chaque substrat est transféré du premier sas MLL **103** vers la chambre de procédé **100** pour y subir un traitement, via la chambre de transfert **102** grâce à la pelle du robot de la chambre de transfert **102.** Dès le traitement terminé dans la chambre de procédé **100,** le substrat est transféré vers un deuxième sas MLL **107** également connecté à la chambre de transfert **102,** ce qui permet ainsi de stocker sous vide les substrats traités sans contact avec les substrats qui ne sont pas encore traités, restés dans le premier sas MLL **103,** et d'éviter ainsi toute contamination.

Une deuxième application est la qualification d'un procédé («hot lot» en anglais) pour permettre de vérifier si les installations de traitement ont conservé les mêmes spécifications, et ainsi de qualifier une chaîne d'équipements de traitement qui entrent dans les différentes étapes d'un procédé.

Une première boite de transport **104,** connectée à un premier sas de chargement / déchargement mobile MLL **103** et contenant le lot complet de substrats à traiter, attend sous vide connectée à l'équipement. Une deuxième boîte de transport 108 ne contenant qu'un seul substrat est connecté à un deuxième sas de chargement / déchargement mobile MLL **107.** Le substrat de qualification est transféré dans la chambre de procédé **100** pour subir le traitement. Il est ensuite ramené dans la deuxième boite de transport **108** par le sas MLL **107** à laquelle la boîte de transport **108** est connectée. La deuxième boite de transport **108** est ensuite transportée vers une autre installation de traitement afin de réaliser la même suite d'opérations qui vient d'être décrites, et ce jusqu'à ce que le substrat ait subit toutes les étapes du procédé à qualifier sur tous les équipements dédiés. A la fin de ces différentes étapes, le substrat est analysé; les résultats de cette analyse permettent de valider les équipements de traitement mis en oeuvre dans la chaîne de fabrication pour réaliser ce procédé, ainsi que les traitements qui vont être mis en oeuvre.

Un substrat de décontamination utilisé dans cette application particulière («gather» en anglais) peut être transféré successivement dans les différentes chambres de procédé d'une installation de traitement et laissé un laps de temps dans chaque chambre de procédé. Cette opération permet de décontaminer chaque chambre. Dès que le substrat a finit de circuler dans toutes les chambres de l'installation de traitement, la boite de transport **108** est déconnectée du sas MLL **107** pour permettre de récupérer le substrat afin qu'il soit analysé ou jeté.

Certains procédés élèvent la température des substrats. Si le substrat reste chaud après le traitement, on peut le laisser refroidir sous vide dans le sas MLL ou dans la boite de transport ce qui évite les problèmes d'oxydation. Ceci n'est pas possible dans les installations classiques.

Le dispositif MLL peut être aussi utilisé pour mélanger ou compléter un lot de substrats contenu dans la boite de transport **104, 108** connectée à un sas MLL **103, 107** avec des substrats provenant de la boîte de transport **106** communiquant avec le module EFEM **105**. Ces manipulations sont effectuées aujourd'hui par des appareils appelés « sorter » ou « stocker » en anglais.

La maintenance des sas de chargement / déchargement MLL **103** s'effectue avec plus de facilité et sans interruption de la fabrication. Dans un premier temps, la boite de transport **104** est déconnectée du sas de chargement / déchargement MLL **103.** Puis le sas MLL **103** est remis à la pression atmosphérique. La porte du sas **103** est alors ouverte, donnant accès au volume intérieur de celui-ci pour procéder à sa maintenance. L'installation peut continuer à travailler avec les substrats provenant de la deuxième boite de transport **108** par l'intermédiaire du sas de chargement / déchargement MLL **107.** Cela représente un gain de temps et de coût important pour la fabrication de composants semiconducteurs, par rapport à la situation actuelle qui oblige à l'arrêt complet de l'installation. En effet la chambre de transfert et le module EFEM doivent actuellement être déconnectées du sas de chargement /déchargement afin de permettre l'accès à l'intérieur de celui-ci.

## Revendications

1. Dispositif (71) apte à coopérer avec au moins deux équipements de traitement de substrats, ledit dispositif comportant des parois étanches aptes à pouvoir supporter et conserver le vide, comprenant :
- un premier orifice (73) comprenant des moyens de connexion à un premier équipement choisi parmi une chambre de transfert et une chambre de procédé,
- un deuxième orifice (72) comprenant des moyens de connexion à une boîte de transport (70) de substrats
- un panier (77) destiné à être contenu dans une boite de transport de substrats, comprenant une série de plateaux (79) parallèles empilés, adaptés pour stocker chacun une plaquette (78) de substrat et des cales (53 ; 81) disposées entre les plateaux (79) et les plaquettes (78) de substrat, le panier (77) étant susceptible d'être transporté à l'intérieur des parois du dispositif (71),
- des moyens de déplacement du panier (77) de et vers la boîte de transport,
- des moyens (80) de blocage des plateaux (79),
**caractérisé en ce qu'**il comprend en outre
- un troisième orifice (74) comprenant des moyens de connexion à un deuxième équipement choisi parmi un module EFEM et une chambre de transfert, et
- des moyens de pose et de soutien (27) d'une plaquette (78) de substrat dans une position donnée, aptes à coopérer avec des moyens de déplacement (83) de la plaquette (78) de substrat du premier ou du deuxième équipement pour permettre son passage à travers le premier orifice (73) ou le troisième orifice (74), les moyens de pose et de soutien (27) d'une plaquette (78) de substrat comprenant :
- deux bras de pose (50 ; 82) déplaçables, positionnés en vis-à-vis sur deux parois du dispositif, perpendiculaires aux parois du dispositif où sont situés les premier et troisième orifices, et
- les cales (53; 81) disposées entre les plateaux (79) et les plaquettes (78) de substrat, adaptées à autoriser le passage des bras de pose (50).

2. Dispositif selon la revendication 1, comportant en outre des moyens d'actionnement de porte pour ouvrir et fermer la porte obturant respectivement chaque orifice.

3. Dispositif selon l'une des revendications 1 et 2, comportant en outre des moyens d'étanchéité au niveau de la zone d'accouplement d'un orifice à un équipement.

4. Dispositif selon l'une des revendications1 à 3, dans lequel les moyens de blocage des plateaux comportent des doigts de verrouillage coopérant avec des moyens d'actionnement de doigts.

5. Dispositif selon la revendication 4, dans lequel le doigt de verrouillage est muni d'une encoche qui coopère avec le plateau.

6. Installation pour le traitement de substrats comprenant une chambre de procédé communiquant avec une première chambre de transfert, et au moins un dispositif selon l'une des revendications 1 à 5, communiquant avec la première chambre de transfert, avec un module EFEM ou une deuxième chambre de transfert, et avec une boite de transport.

7. Installation pour le traitement de substrats comprenant une chambre de procédé et au moins un dispositif selon l'une des revendications 1 à 5, communiquant avec la chambre de procédé, avec un module EFEM ou une chambre de transfert, et avec une boîte de transport.

8. Utilisation de l'installation selon la revendication 7, pour le stockage intermédiaire des plaquettes de substrat sans déconnection du dispositif de l'installation et pour le tri d'un lot de substrat ou le mélange de substrats provenant de lots différents.

## Patentansprüche

1. Vorrichtung (71), die geeignet ist, mit mindestens zwei Ausrüstungen zur Verarbeitung von Substraten zusammenzuwirken, wobei die Vorrichtung dichte Wände umfasst, die geeignet sind, das Vakuum unterstützen und bewahren zu können, umfassend:
- eine erste Öffnung (73), umfassend Anschlussmittel an eine erste Ausrüstung, die unter einer Transferkammer und einer Verfahrenskammer ausgewählt ist,
- eine zweite Öffnung (72), umfassend Anschlussmittel an eine Transportbox (70) von Substraten,
- einen Korb (77), der dazu bestimmt ist, in einer Transportbox von Substraten enthalten zu sein, umfassend eine Reihe von gestapelten parallelen Platten (79), die geeignet sind, jeweils eine Substratscheibe (78) zu lagern, und Keile (53; 81), die zwischen den Platten (79) und den Substratscheiben (78) angeordnet sind, wobei der Korb (77) geeignet ist, innerhalb der Wände der Vorrichtung (71) transportiert zu werden;
- Mittel zur Verlagerung des Korbs (77) von und zu der Transportbox,
- Mittel (80) zur Feststellung der Platten (79) ,
**dadurch gekennzeichnet, dass** sie ferner umfasst
- eine dritte Öffnung (74), umfassend Anschlussmittel an eine zweite Ausrüstung, die unter einem EFEM-Modul und einer Transferkammer ausgewählt ist, und
- Mittel zum Aufstellen und Halten (27) einer Substratscheibe (78) in einer gegebenen Position, die geeignet sind, mit Verlagerungsmitteln (83) der Substratscheibe (78) der ersten oder der zweiten Ausrüstung zusammenzuwirken, um ihren Durchgang durch die erste Öffnung (73) oder die dritte Öffnung (74) zu ermöglichen, wobei die Mittel zum Aufstellen und Halten (27) einer Substratscheibe (78) umfassen:
- zwei verschiebbare Aufstellarme (50; 82), die einander gegenüber auf zwei Wänden der Vorrichtung positioniert sind, senkrecht zu den Wänden der Vorrichtung, wo sich die ersten und dritten Öffnungen befinden, und
- die Keile (53; 81), die zwischen den Platten (79) und den Substratscheiben (78) angeordnet und geeignet sind, den Durchgang der Aufstellarme (50) zu gestatten.

2. Vorrichtung nach Anspruch 1, ferner umfassend Betätigungsmittel einer Tür, um die Tür, die jeweils jede Öffnung verschließt, zu öffnen und zu schließen.

3. Vorrichtung nach einem der Ansprüche 1 und 2, ferner umfassend Dichtungsmittel im Bereich der Kopplungszone einer Öffnung mit einer Ausrüstung.

4. Vorrichtung nach einem der Ansprüche 1 bis 3, bei der die Feststellungsmittel der Platten Verriegelungsfinger umfassen, die mit Betätigungsmitteln von Fingern zusammenwirken.

5. Vorrichtung nach Anspruch 4, bei der der Verriegelungsfinger mit einer Kerbe versehen ist, die mit der Platte zusammenwirkt.

6. Anlage zur Verarbeitung von Substraten, umfassend eine Verfahrenskammer, die mit einer ersten Transferkammer in Verbindung steht, und mindestens eine Vorrichtung nach einem der Ansprüche 1 bis 5, die mit der ersten Transferkammer, mit einem EFEM-Modul oder einer zweiten Transferkammer und mit einer Transportbox in Verbindung steht.

7. Anlage zur Verarbeitung von Substraten, umfassend eine Verfahrenskammer und mindestens eine Vorrichtung nach einem der Ansprüche 1 bis 5, die mit der Verfahrenskammer, mit einem EFEM-Modul oder einer Transferkammer und mit einer Transportbox in Verbindung steht.

8. Verwendung der Anlage nach Anspruch 7 zur Zwischenlagerung der Substratscheiben ohne Trennung der Vorrichtung von der Anlage, und zum Sortieren einer Substratmenge oder des Gemisches von Substraten, die von unterschiedlichen Mengen kommen.

## Claims

1. Device (71) able to cooperate with at least two items of substrate processing equipment, the said device comprising fluidtight walls capable of being able to withstand and maintain a vacuum, comprising:
- a first port (73) comprising means of connection to a first item of equipment chosen from a transfer chamber and a process chamber,
- a second port (72) comprising means of connection to a substrate transport pod (70)
- a basket (77) intended to be contained inside a substrate transport pod, comprising a series of stacked parallel trays (79) configured to each store a substrate wafer (78) and shims (53; 81) placed between the trays (79) and the substrate wafers (78), the basket (77) being able to be transported within the walls of the device (71),
- means (77) of moving the basket from and toward the transport pod,
- means (80) for immobilizing the trays (79),
**characterized in that** it further comprises
- a third port (74) comprising means of connection to a second item of equipment chosen from an EFEM and a transfer chamber, and
- means (27) for setting down and supporting a substrate wafer (78) in a given position, these means being able to cooperate with means (83) for moving the substrate wafer (78) of the first or second item of equipment so as to allow it to pass through the first port (73) or the third port (74), the means (27) for setting down and supporting a substrate wafer (78) comprising:
- two movable setting-down arms (50; 82) positioned facing each other on two walls of the device and perpendicular to the walls of the device in which the first and third ports are situated, and
- shims (53; 81) positioned between the trays (79) and the substrate wafers (78), configured to allow the passage of the setting-down arms (50).

2. Device according to Claim 1, further comprising door actuating means so as to open and close the door respectively closing off each port.

3. Device according to one of Claims 1 and 2, further comprising means for sealing at the region of coupling of a port to an item of equipment.

4. Device according to one of Claims 1 to 3, in which the tray immobilizing means comprise locking fingers cooperating with finger actuating means.

5. Device according to Claim 4, in which the locking finger is provided with a notch which cooperates with the tray.

6. Installation for the treatment of substrates, comprising a process chamber communicating with a first transfer chamber and at least one device according to one of Claims 1 to 5, communicating with the first transfer chamber, with an EFEM or a second transfer chamber and with a transport pod.

7. Installation for treating substrates comprising a process chamber and at least one device according to one of Claims 1 to 5 communicating with the process chamber, with an EFEM or a transfer chamber and with a transport pod.

8. Use of the installation according to Claim 7 for the intermediate storage of substrate wafers without disconnecting the device from the installation and for sorting a batch of substrates or for mixing substrates originating from different batches.
